# EUROPEAN PATENT APPLICATION

(11) **EP 4 618 163 A1**
(43) Date of publication of application: **17.09.2025**
(21) Application number: 24178684.7
(22) Date of filing: 29.05.2024
(51) Int. Cl.: H01L 31/0224, H01L 31/18

(54) **BACK CONTACT SOLAR CELL, METHOD FOR PREPARING THE SAME, AND BATTERY ASSEMBLY**

(30) Priority: 11.03.2024 CN 202410274594
(71) Applicant: Trina Solar Co., Ltd., Changzhou, Jiangsu 213031 (CN)
(72) Inventor: HU, Yunyun, Changzhou, 213031 (CN); YANG, Guangtao, Changzhou, 213031 (CN); CHEN, Yifeng, Changzhou, 213031 (CN)
(74) Representative: Zacco Sweden AB

(57) **Abstract**

The present disclosure provides a back contact solar cell, a method for preparing a back contact solar cell, and a battery assembly. The present disclosure relates to the technical field of crystalline silicon solar cells. The back contact solar cell includes: a semiconductor substrate having a light receiving surface and a shady surface opposite to the light receiving surface, a first polarity structure formed in the first polarity region, and a second polarity structure formed in the second polarity region. The light receiving surface is a textured surface, and a surface of the first polarity region and a surface of the second polarity region are polished surfaces. According to the back contact solar cell of the present disclosure, a shady surface of the semiconductor substrate is combined with a passivation contact technology to form a hybrid back contact cell. Meanwhile, the shady surface of the semiconductor substrate is processed as a polished surface, which lowers an interface defect and carrier recombination of a heterojunction region of the shady surface, thereby enabling the solar cell to have a high open-circuit voltage and photoelectric conversion efficiency.

## Description

### FIELD

The present disclosure relates to the technical field of crystalline silicon solar cells, and in particular, to a back contact solar cell, a method for preparing a back contact solar cell, and a battery assembly.

### BACKGROUND

With the mature and continuous explorations of passivated emitter and rear cell (PERC) technology, a theoretical limit of conversion efficiency of the PERC technology is gradually approached, and the industry starts to seek a next generation technology. At present, the mainstream technologies being promoted include a tunnel oxide passivated contact (TOPCon) cell, a heterojunction (HJT) cell, an interdigitated back contact (IBC) cell, and the like.

Distinguished from a cell in the related technologies with double-sided electrode contact, a maximum characteristic of a back contact (BC) cell is that a metal electrode is located at a shady surface of the cell, and a front surface of the cell has no metal electrode for shielding, so that a utilization rate of light is improved. Therefore, the cell has a high short-circuit current and conversion efficiency. In various BC technologies, a hybrid back contact (HBC) technology has the highest photoelectric conversion efficiency. By adopting the hybrid technology, a passivation contact technology is applied to the shady surface of the cell to form an HBC cell. At present, photoelectric conversion efficiency of the HBC cell still needs to be improved. Therefore, how to improve the photoelectric conversion efficiency of the HBC cell is an urgent technical problem to be solved.

### SUMMARY

The present disclosure aims to at least solve one of the technical problems existing in the prior art. To this end, the present disclosure provides a back contact solar cell, a method for preparing a back contact solar cell, and a battery assembly, which lowers interface defects and carrier recombination of a heterojunction region of a shady surface and has a high open-circuit voltage and photoelectric conversion efficiency. In addition, the process is simplified and is suitable for large-scale mass production.

According to a first aspect, the present disclosure provides a back contact solar cell, including: a semiconductor substrate having a light receiving surface and a shady surface opposite to the light receiving surface, and the shady surface includes a first polarity region and a second polarity region that are arranged alternately in a first direction. The light receiving surface is a textured surface, and a surface of the first polarity region and a surface of the second polarity region being polished surfaces. The back contact solar cell further includes a first polarity structure formed in the first polarity region and including a first functional layer and a first electrode structure that are stacked in a direction away from the semiconductor substrate. The first functional layer includes a first passivation layer and a first doped semiconductor layer that are stacked in the direction away from the semiconductor substrate, and a side surface of the first passivation layer facing towards the semiconductor substrate is a polished surface. The back contact solar cell further includes a second polarity structure formed in the second polarity region and including a second functional layer and a second electrode structure that are stacked in the direction away from the semiconductor substrate, and the second functional layer includes a second passivation layer and a second doped semiconductor layer that are stacked in the direction away from the semiconductor substrate. A side surface of the second passivation layer facing towards the semiconductor substrate is a polished surface. A doping type of the first doped semiconductor layer is opposite to a doping type of the second doped semiconductor layer.

According to the back contact solar cell in the present disclosure, a shady surface of the semiconductor substrate is combined with a passivation contact technology to form a hybrid back contact (HBC) cell. Meanwhile, the shady surface of the semiconductor substrate is made into the polished surface. In this way, the interface defects and carrier recombination of the heterojunction region of the shady surface are lowered, enabling the solar cell to have the high open-circuit voltage and photoelectric conversion efficiency.

According to an embodiment of the present disclosure, the second functional layer at least partially extends to the first polarity region, and a first orthographic projection of the first functional layer on the semiconductor substrate at least partially overlaps with a second orthographic projection of the second functional layer on the semiconductor substrate. The first functional layer is in direct contact with the second functional layer, or an insulation layer is arranged between the first functional layer and the second functional layer. The insulation layer includes at least one of phosphorosilicate glass or borosilicate glass, silicon oxide, silicon nitride, and silicon oxynitride.

According to an embodiment of the present disclosure, an opening is defined between the first electrode structure and the second electrode structure adjacent to the first electrode structure, and a third orthographic projection of the opening on the semiconductor substrate is located in an overlapping region of the first orthographic projection and the second orthographic projection.

According to an embodiment of the present disclosure, the first electrode structure includes a first conductive layer and a first electrode. The first conductive layer is located at a side of the first doped semiconductor layer away from the first passivation layer, and the first electrode is located at a side of the first conductive layer away from the first doped semiconductor layer. The second electrode structure includes a second conductive layer and a second electrode. The second conductive layer is located at a side of the second doped semiconductor layer away from the second passivation layer, and second first electrode is located at a side of the second conductive layer away from the second doped semiconductor layer. Each of the first conductive layer and the second conductive layer includes at least one of zinc oxide, indium oxide, and tin oxide. Each of the first conductive layer and the second conductive layer is doped with at least one of gallium element, tin element, titanium element, zirconium element, molybdenum element, cerium element, fluorine element, tungsten element, or aluminum element, and each of the first conductive layer and the second conductive layer has a thickness ranging from 10 nm to 150 nm.

According to an embodiment of the present disclosure, the semiconductor substrate further includes a doped substrate layer located in the first polarity region and formed on a side of the first polarity region close to the first passivation layer. A doping type of the doped substrate layer is the same as the doping type of the first doped semiconductor layer; and the doped substrate layer has a thickness ranging from 5 nm to 200 nm.

According to an embodiment of the present disclosure, a distance between the surface of the first polarity region and the light receiving surface is greater than a distance between the surface of the second polarity region and the light receiving surface.

According to an embodiment of the present disclosure, the first passivation layer includes a tunnel oxide and has a thickness ranging from 0.5 nm to 2.5 nm. The first doped semiconductor layer includes doped polysilicon and has a thickness ranging from 10 nm to 250 nm. The second passivation layer includes intrinsic amorphous silicon and has a thickness ranging from 1 nm to 15 nm. The second doped semiconductor layer includes doped amorphous silicon and/or microcrystalline silicon and has a thickness ranging from 1 nm to 60 nm.

According to an embodiment of the present disclosure, the back contact solar cell further includes a third functional layer and an anti-reflection layer formed on the light-receiving surface of the semiconductor substrate. The third functional layer and the anti-reflection layer are stacked in the direction away from the semiconductor substrate. The third functional layer includes at least one of intrinsic amorphous silicon, a composite layer of intrinsic amorphous silicon and doped thin film silicon, silicon oxide, silicon nitride, silicon oxynitride, or aluminum oxide. The anti-reflection layer includes at least one of silicon oxide, silicon nitride, silicon oxynitride, aluminum oxide, and transparent conductive oxide.

In a second aspect, the present disclosure provides a method for preparing a back contact solar cell, including: providing a semiconductor substrate, the semiconductor substrate having a light-receiving surface and a shady surface opposite to the light-receiving surface. The shady surface includes a first polarity region and a second polarity region that are arranged alternately in a first direction. The method further includes processing a surface of the semiconductor substrate to turn the light-receiving surface into a textured surface, and turn a surface of the first polarity region and a surface of the second polarity region into polished surfaces, and forming a first polarity structure in the first polarity region and a second polarity structure in the second polarity region. The first polarity structure includes a first functional layer and a first electrode structure that are stacked in a direction away from the semiconductor substrate. The first functional layer includes a first passivation layer and a first doped semiconductor layer that are stacked in the direction away from the semiconductor substrate. A side surface of the first passivation layer facing towards the semiconductor substrate is a polished surface. A second polarity structure includes a second functional layer and a second electrode structure that are stacked in the direction away from the semiconductor substrate. The second functional layer includes a second passivation layer and a second doped semiconductor layer that are stacked in the direction away from the semiconductor substrate. A side surface of the second passivation layer facing towards the semiconductor substrate is a polished surface. A doping type of the first doped semiconductor layer is opposite to a doping type of the second doped semiconductor layer.

According to the method for preparing the back contact solar cell of the present disclosure, the HBC cell is formed on the shady surface of the semiconductor substrate in combination with the passivation contact technology, and meanwhile, by forming the shady surface of the semiconductor substrate as the polished surface, the interface defect and carrier recombination of the heterojunction region of the shady surface are lowered, so that the solar cell has the high open-circuit voltage and photoelectric conversion efficiency. In addition, compared with an existing HBC cell process, the preparation method proposed in the present disclosure is simplified, which is beneficial to large-scale mass production.

According to an embodiment of the present disclosure, the processing a surface of the semiconductor substrate to turn the light-receiving surface into a textured surface, and turn a surface of the first polarity region and a surface of the second polarity region into polished surfaces includes: texturing the light receiving surface and the shady surface of the semiconductor substrate; forming a mask on the light receiving surface of the semiconductor substrate; polishing the shady surface of the semiconductor substrate; and removing the mask.

According to an embodiment of the present disclosure, a remaining thicknesses of the mask after polishing the shady surface of the semiconductor substrate ranges from 10 nm to 100 nm. The mask is made of at least one of silicon oxide, silicon nitride, and silicon oxynitride.

According to an embodiment of the present disclosure, the method for preparing a back contact solar cell, before processing a surface of the semiconductor substrate to turn the light-receiving surface into a textured surface, and turn a surface of the first polarity region and a surface of the second polarity region into polished surfaces, further includes: performing gettering treatment on the semiconductor substrate.

According to an embodiment of the present disclosure, the performing gettering treatment on the semiconductor substrate includes: removing a sacrificial layer of the semiconductor substrate by wet etching; performing gettering treatment on the semiconductor substrate by high-temperature phosphorus diffusion; and removing a gettering-treated layer formed in the gettering treatment on the semiconductor substrate by wet etching.

According to an embodiment of the present disclosure, the forming a first polarity structure in the first polarity region and a second polarity structure in the second polarity region includes: forming the first functional layer on the shady surface of the semiconductor substrate; etching a first region corresponding to the second polarity region of the semiconductor substrate to remove the first functional layer in the first region and a part of the semiconductor substrate with a first thickness; forming the second functional layer on the shady surface of the semiconductor substrate, the second functional layer covering the first functional layer; etching a second region in the first polarity region of the semiconductor substrate to remove the second functional layer in the second region and a part of the first functional layer with a second thickness; forming a conductive layer over the shady surface of the semiconductor substrate, the conductive layer covering the first functional layer and the second functional layer; forming an opening in each of overlapping regions of the first functional layer and the second functional layer, the opening at least penetrating the conductive layer and at most exposing the first functional layer; and forming an electrode in each of the first region and the second region, the electrode being in contact with the conductive layer.

According to an embodiment of the present disclosure, the first functional layer in the first region and the part of the semiconductor substrate with the first thickness are removed by using a wet chemical etching liquid. The wet chemical etching liquid includes an alkaline polishing liquid.

According to an embodiment of the present disclosure, the method for preparing a back contact solar cell, after forming the second functional layer on the shady surface of the semiconductor substrate, further includes: forming a third functional layer and an anti-reflection layer sequentially on the light receiving surface of the semiconductor substrate.

In a third aspect, the present disclosure provides a battery assembly, including the back contact solar cell as described above, or a back contact solar cell prepared by the method for preparing a back contact solar cell as described above.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is a first schematic diagram of a cross-sectional structure of a back contact solar cell according to an embodiment of the present disclosure;
FIG. 2 is a second schematic diagram of a cross-sectional structure of a back contact solar cell according to an embodiment of the present disclosure;
FIG. 3 is a schematic flowchart of a method for preparing a back contact solar cell according to an embodiment of the present disclosure;
FIG. 4 is a first schematic diagram of a cross-sectional structure of a stage in a method for preparing a back contact solar cell according to an embodiment of the present disclosure;
FIG. 5 is a second schematic diagram of a cross-sectional structure of a stage in a method for preparing a back contact solar cell according to an embodiment of the present disclosure;
FIG. 6 is a third schematic diagram of a cross-sectional structure of a stage in a method for preparing a back contact solar cell according to an embodiment of the present disclosure;
FIG. 7 is a fourth schematic diagram of a cross-sectional structure of a stage in a method for preparing a back contact solar cell according to an embodiment of the present disclosure;
FIG. 8 is a fifth schematic diagram of a cross-sectional structure of a stage in a method for preparing a back contact solar cell according to an embodiment of the present disclosure;
FIG. 9 is a sixth schematic diagram of a cross-sectional structure of a stage in a method for preparing a back contact solar cell according to an embodiment of the present disclosure;
FIG. 10 is a seventh schematic diagram of a cross-sectional structure of a stage in a method for preparing a back contact solar cell according to an embodiment of the present disclosure; and
FIG. 11 is an eighth schematic diagram of a cross-sectional structure of a stage in a method for preparing a back contact solar cell according to an embodiment of the present disclosure.

### Reference numerals:

semiconductor substrate 1, first functional layer 2, first passivation layer 2-1, first doped semiconductor layer 2-2, doped substrate layer 3, insulation layer 4, second functional layer 5, second passivation layer 5-1, second doped semiconductor layer 5-2, third functional layer 6, anti-reflection layer 7, conductive layer 8, first conductive layer 8-1, second conductive layer 8-2, first electrode 9, second electrode 10, first polarity region A, second polarity region B, mask M1, first surface S1, second surface S2, third surface S3, first opening G1, second opening G2, third opening G3.

### DETAILED DESCRIPTION OF THE EMBODIMENTS

The embodiments of the present disclosure will be described in detail below with reference to examples thereof as illustrated in the accompanying drawings. In the accompanying drawings, sizes of layers, regions, elements, and their relative sizes may be exaggerated for clarity. Throughout the accompanying drawings, same or similar elements, or elements having same or similar functions, are denoted by same or similar reference numerals. The embodiments described below with reference to the drawings are illustrative only, and are intended to explain, rather than limiting, the present disclosure.

It should be understood that when being referred to as being "above", "adjacent to", "connected to", or "coupled to" other elements or layers, an element or layer may be directly on, adjacent to, connected to, or coupled to other elements or layers, or intervening elements or layers may occur. On the contrary, when an element is referred to as being "directly on", "directly adj acent to", "directly connected to", or "directly coupled to" other elements or layers, no intervening elements or layers occurs. It should be understood that although terms first, second, third, etc. may be used to describe various elements, components, regions, layers and/or parts, these elements, components, regions, layers and/or parts should not be limited by these terms. These terms are only used to distinguish one element, component, region, layer or part from another element, component, region, layer or part. Thus, a first element, component, region, layer, or part discussed below may be represented as a second element, component, region, layer, or part without departing from the teachings of the present disclosure. However, when the second element, component, region, layer or part is discussed, it does not indicate that the present disclosure necessarily has a first element, a component, a region, a layer, or a part.

In the description of this specification, descriptions with reference to the terms "an embodiment," "some embodiments," "schematic embodiments," "examples," "specific examples," or "some examples", etc. mean that specific features, structure, materials or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner.

In the related art, a structure of a hybrid back contact (HBC) cell is generally that a TOPCon region at a back of the HBC cell is polished morphology, and that a heterojunction region at the back of the HBC cell and a heterojunction region at a front of the HBC cell are textured morphology. In this way, the purpose of doing so is to have a simple process flow. However, compared with an interface area of a polished surface, an interface area of a textured surface is increased, so interface defects and carrier recombination on the textured surface are severer than those of the polished surface, resulting in passivation of the heterojunction region at the back of the HBC cell not reaching the optimum, thereby affecting efficiency of the cell. Moreover, a current process flow of the HBC cell is still complex, which is not conducive to large-scale mass production.

The present disclosure provides a back contact solar cell, a method for preparing a back contact solar cell, and a battery assembly. The HBC cell is formed at a shady surface of the semiconductor substrate in combination with a passivation contact technology. Meanwhile, by forming a shady surface of the semiconductor substrate as the polished surface, interface defects and carrier recombination of a heterojunction region of the shady surface are lowered, so that a solar cell has a high open-circuit voltage and photoelectric conversion efficiency. In addition, compared with an existing HBC cell process, the preparation method proposed in the present disclosure is simplified, which is beneficial to large-scale mass production.

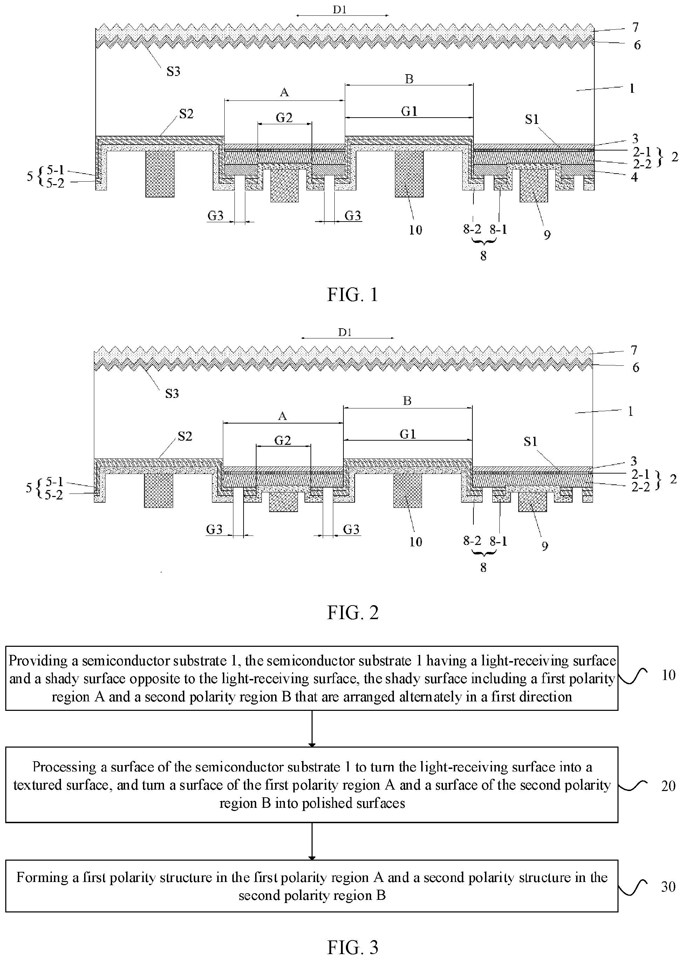

Referring to FIG. 1, FIG. 1 shows a cross-sectional structure of a back contact solar cell. An embodiment of the present disclosure provides a back contact solar cell.

In an embodiment, the back contact solar cell includes a semiconductor substrate 1, a first polarity structure, and a second polarity structure. The semiconductor substrate 1 has a light receiving surface and a shady surface opposite to the light receiving surface. The shady surface includes a first polarity region A and a second polarity region B that are arranged alternately in a first direction D 1. The light receiving surface is a textured surface, and a surface of the first polarity region A and a surface of the second polarity region B are polished surfaces. The first polarity structure is formed in the first polarity region A and includes a first functional layer 2 and a first electrode structure that are stacked in a direction away from the semiconductor substrate 1. The first functional layer 2 includes a first passivation layer 2-1 and a first doped semiconductor layer 2-2 that are stacked in the direction away from the semiconductor substrate 1. A side surface of the first passivation layer 2-1 facing towards the semiconductor substrate 1 is a polished surface. The second polarity structure is formed in the second polarity region B and includes a second functional layer 5 and a second electrode structure that are stacked in the direction away from the semiconductor substrate 1. The second functional layer 5 includes a second passivation layer 5-1 and a second doped semiconductor layer 5-2 that are stacked in the direction away from the semiconductor substrate 1. A side surface of the second passivation layer 5-1 facing towards the semiconductor substrate 1 is a polished surface. A doping type of the first doped semiconductor layer 2-2 is opposite to a doping type of the second doped semiconductor layer 5-2.

In some embodiments, the semiconductor substrate 1 includes materials such as monocrystalline silicon, germanium, or gallium arsenide. The doping type of the semiconductor substrate 1 may be N-type doping or P-type doping.

As shown in FIG. 1, in the first direction D1, the first polarity region A and the second polarity region B are arranged alternately. A first opening G1 is formed at a shady surface of the semiconductor substrate 1 and is configured to form the second polarity region B. A surface of the first polarity region A is represented as a first surface S1. A surface of the second polarity region B is represented as a second surface S2. A light receiving surface of the semiconductor substrate 1 is represented as a third surface S3.

In some embodiments, a distance between the first surface S1 of the first polarity region A and the third surface S3 is greater than a distance between the second surface S2 of the second polarity region B and the third surface S3. Therefore, when the first opening G1 is formed, it is facilitated that an original film layer of the first polarity region A is ensured to be completely removed.

The first surface S1 and the second surface S2 are polished surface structures. For example, the first surface S1 and the second surface S2 may be polished surface topography after being subjected to polished processing. A conventional alkaline polishing liquid may be adopted in the polished processing for polished processing.

Since the shady surface of the semiconductor substrate 1 is made as the polished surface, an interface area between the shady surface of the semiconductor substrate 1 and the polarity structure is reduced, thereby lowering the interface defects and carrier recombination of the heterojunction region of the shady surface, and improving the open-circuit voltage and photoelectric conversion efficiency of the back contact solar cell.

The third surface S3 is a textured structure, for example, pyramid textured surface morphology and/or corrosion pit textured surface morphology.

In some embodiments, the semiconductor substrate 1 further includes a doped substrate layer 3. The doped substrate layer 3 is arranged in a side of the first polarity region A close to the first passivation layer 2-1. A doping type of the doped substrate layer 3 is the same as the doping type of the first doped semiconductor layer 2-2.

A surface of a side of the doped substrate layer 3 close to the first passivation layer 2-1 is a polished surface. The doped substrate layer 3 is formed by doping a part of the semiconductor substrate 1. For example, a part of the semiconductor substrate 1 in the first polarity region A accepts doping of particles like boron to form a P-type doped substrate layer 3, or doping of particles like arsenic and phosphorus to form an N-type doped substrate layer 3.

In some embodiments, the doped substrate layer 3 has a thickness ranging from 5 nm to 200 nm. For example, the thickness of the doped substrate layer 3 may be 5 nm, 50 nm, 100 nm, or 200 nm.

In some embodiments, a material of the first passivation layer 2-1 includes a tunnel oxide, and the first passivation layer 2-1 has a thickness ranging from 0.5 nm to 2.5 nm. For example, the thickness of the first passivation layer 2-1 may be 0.5 nm, 1.5 nm, 2.5 nm, or the like. Therefore, the first surface S1 has a better passivation effect, and a multi-sub-tunneling effect is ensured simultaneously.

A side surface of the first passivation layer 2-1 close to the semiconductor substrate 1 is also a polished surface. Therefore, an interface area of the first passivation layer 2-1 and an interface area of the semiconductor substrate 1 are reduced, thereby lowering a recombination probability of carriers at an interface between the first passivation layer 2-1 and the semiconductor substrate 1.

In some embodiments, a material of the first doped semiconductor layer 2-2 includes doped polysilicon, and the first doped semiconductor layer 2-2 has a thickness ranging from 10 nm to 250 nm. For example, the thickness of the first doped semiconductor layer 2-2 may be 10 nm, 50 nm, 150 nm, 250 nm, or the like. Therefore, a good field passivation effect is achieved. Moreover, the film layer has a relative smaller thickness, and parasitic absorption is reduced.

The doping type of the first doped semiconductor layer 2-2 is the same as or opposite to the doping type of the semiconductor substrate 1. For example, the semiconductor substrate 1 is in an N-type doping type, and the first doped semiconductor layer 2-2 may be the N-type doping or P-type doping.

In some embodiments, the second passivation layer 5-1 includes intrinsic amorphous silicon and has a thickness ranging from 1 nm to 15 nm. For example, the thickness of the second passivation layer 5-1 may be 1 nm, 10 nm, 15 nm, or the like. Therefore, the second surface S2 has a good passivation effect.

A side surface of the second passivation layer 5-1 close to the semiconductor substrate 1 is also a polished surface. Therefore, an interface area of the second passivation layer 5-1 and the interface area of the semiconductor substrate 1 are reduced, and a recombination probability of carriers at an interface between the second passivation layer 5-1 and the semiconductor substrate 1 is further lowered.

In some embodiments, the second doped semiconductor layer 5-2 includes doped amorphous silicon and/or microcrystalline silicon and has a thickness ranging from 1 nm to 60 nm. For example, the thickness of the second doped semiconductor layer 5-2 may be 1 nm, 30 nm, 60 nm, or the like. Therefore, a good field passivation effect is achieved. Moreover, the thickness of the film layer is small, and the parasitic absorption is reduced.

The doping type of the second doped semiconductor layer 5-2 is opposite to the doping type of the first doped semiconductor layer 2-2. For example, the first doped semiconductor layer 2-2 is N-type doping, and the second doped semiconductor layer 5-2 may be P-type doping.

In some embodiments, the second functional layer 5 at least partially extends to the first polarity region A, and a first orthographic projection of the first functional layer 5 on the semiconductor substrate 1 at least partially overlaps with a second orthographic projection of the second functional layer 5 on the semiconductor substrate 1.

In the first direction D1, the second passivation layer 5-1 and the second doped semiconductor layer 5-2 each extend towards the first polarity region A at each of two sides and partially overlap with the first passivation layer 2-1 and the first doped semiconductor layer 2-2 of the first polarity regions A located at the two sides, and an orthographic projection of the overlapping part on the semiconductor substrate 1 is located in the first polarity region A. Therefore, in the first direction D1, the first polarity region A has the overlapping part at each of two sides of the first polarity region A.

As shown in FIG. 1, an insulation layer 4 is arranged between the first functional layer 2 and the second functional layer 5. At an overlapping part of the first functional layer 2 and the second functional layer 5, an insulation layer 4 is arranged between the second passivation layer 5-1 and the first doped semiconductor layer 2-2. Therefore, a leakage current can be reduced. The insulation layer 4 includes at least one of phosphorosilicate glass or borosilicate glass, silicon oxide, silicon nitride, and silicon oxynitride.

Referring to FIG. 2, another cross-sectional structure of a back contact solar cell is shown. In some other embodiments, the first functional layer 2 is in direct contact with the second functional layer 5.

As shown in FIG. 2, at the overlapping part of the first functional layer 2 and the second functional layer 5, the second passivation layer 5-1 is in direct contact with the first doped semiconductor layer 2-2. Therefore, a passivation quality at an interface of the first polarity region A and the second polarity region B can be improved.

In some embodiments, the first electrode structure includes a first conductive layer 8-1 and a first electrode. The first conductive layer 8-1 is located at a side of the first doped semiconductor layer 2-2 away from the first passivation layer 2-1, and the first electrode is located at a side of the first conductive layer 8-1 away from the first doped semiconductor layer 2-2. The second electrode structure includes a second conductive layer 8-2 and a second electrode. The second conductive layer 8-2 is located at a side of the second doped semiconductor layer 5-2 away from the second passivation layer 5-1, and second first electrode is located at a side of the second conductive layer 8-2 away from the second doped semiconductor layer 5-2.

The first electrode structure may have a P-polarity, and the second electrode structure may have an N-polarity. Alternatively, the first electrode structure may have the N-polarity, and the second electrode structure may have the P-polarity. The polarity of the first electrode structure and the polarity of the second electrode structure depend on their doping types in the functional layers with which they are in contact.

The first electrode structure includes a first conductive layer 8-1 and a first electrode 9. A second opening G2 is formed at the side of the first doped semiconductor layer 2-2 away from the first passivation layer 2-1. The first conductive layer 8-1 covers the second opening G2 and extends towards two sides of the second opening G2 in the first direction D1. The first electrode 9 is located at the side of the first conductive layer 8-1 away from the first doped semiconductor layer 2-2.

A part of the first conductive layer 8-1 extending out of the second opening G2 and the first functional layer 2 is spaced apart by a part of the second functional layer 5, i.e., the first conductive layer 8-1 and the first doped semiconductor layer 2-2 are spaced apart by an insulation layer 4, a second passivation layer 5-1, and a second doped semiconductor layer 5-2 or by a second passivation layer 5-1 and a second doped semiconductor layer 5-2.

The second electrode structure includes a second conductive layer 8-2 and a second electrode 10. The second conductive layer 8-2 is formed at the side of the second doped semiconductor layer 5-2 away from the second passivation layer 5-1 and covers the second polarity region B. The second electrode 10 is located at the side of the second conductive layer 8-2 away from the second doped semiconductor layer 5-2.

In the first direction D 1, each of two sides of the second conductive layer 8-2 at least partially extends to the first polarity region A, and an orthographic projection of the second conductive layer 8-2 on the semiconductor substrate 1 at least partially overlaps with the second orthographic projection of the second functional layer 5 on the semiconductor substrate 1. The second conductive layer 8-2 and the first doped semiconductor layer 2-2 are spaced apart by the insulation layer 4, the second passivation layer 5-1, and the second doped semiconductor layer 5-2 or by the second passivation layer 5-1 and the second doped semiconductor layer 5-2.

In some embodiments, the first conductive layer 8-1 and the second conductive layer 8-2 include a transparent conductive oxide. For example, the first conductive layer 8-1 and the second conductive layer 8-2 are made of at least one of zinc oxide, indium oxide, and tin oxide. The first electrode 9 and the second electrode 10 includes metal materials, such as silver or copper.

In some embodiments, the first conductive layer 8-1 and the second conductive layer 8-2 may be doped with at least one of a gallium element, a tin element, a titanium element, a zirconium element, a molybdenum element, a cerium element, a fluorine element, a tungsten element, or an aluminum element.

In some embodiments, the first conductive layer 8-1 and the second conductive layer 8-2 have a same thickness ranging from 10 nm to 150 nm. For example, the thickness of the first conductive layer 8-1 and the thickness of the second conductive layer 8-2 may be 10 nm, 50 nm, or 150 nm.

In some embodiments, a third opening G3 is formed between a first electrode structure and a second electrode structure adjacent to the first electrode structure, and a third orthographic projection of the third opening G3 on the semiconductor substrate 1 is located in an overlapping region of the first orthographic projection and the second orthographic projection. The first electrode structure and the second electrode structure are isolated by the third opening G3 to avoid a short circuit.

The third opening G3 is located between each first opening G1 and the second opening G2, the third openings G3 is defined to at least space the first conductive layer 8-1 apart from the second conductive layer 8-2, and to at most expose the first functional layer 2. As shown in FIG. 1 or FIG. 2, the first conductive layer 8-1 and the second conductive layer 8-2 are spaced apart by the third opening G3, and the second passivation layer 5-1 and the second doped semiconductor layer 5-2 are penetrated by the third opening G3 to expose the insulation layer 4 or expose the first doped semiconductor layer 2-2.

In some embodiments, the back contact solar cell further includes a third functional layer 6 and an anti-reflection layer 7 that are formed on the light-receiving surface of the semiconductor substrate 1. The third functional layer 6 is in contact with the light receiving surface of the semiconductor substrate 1. The anti-reflection layer 7 is located at a side of the third functional layer 6 away from the semiconductor substrate 1 and is in contact with the third functional layer 6. The light receiving surface of the semiconductor substrate 1 is a textured surface, and a surface of a side of the third functional layer 6 close to the semiconductor substrate 1 is also a textured surface.

The third functional layer 6 includes at least one of intrinsic amorphous silicon, a composite layer of intrinsic amorphous silicon and doped thin film silicon, silicon oxide, silicon nitride, silicon oxynitride, and aluminum oxide, and the anti-reflection layer 7 includes at least one of silicon oxide, silicon nitride, silicon oxynitride, aluminum oxide, and transparent conductive oxide.

Referring to FIG. 3, FIG. 3 shows a flow of a method for preparing a back contact solar cell. The method for preparing a back contact solar cell is further provided according to some embodiments of the present disclosure.

In an embodiment, the method for preparing the back contact solar cell includes operations 10, 20, and 30.

At operation 10, a semiconductor substrate 1 is provided. The semiconductor substrate 1 has a light-receiving surface and a shady surface opposite to the light-receiving surface. The shady surface includes a first polarity region A and a second polarity region B adjacent to the first polarity region A in a first direction.

At operation 20, the light-receiving surface of the semiconductor substrate 1 is processed to form a textured surface, and a surface of the first polarity region A and a surface of the second polarity region B are processed to form polished surfaces.

At operation 30, a first polarity structure in the first polarity region A and a second polarity structure in the second polarity region B are formed, respectively.

In an embodiment, the structure of the back contact solar cell prepared according to the method for preparing the back contact solar cell may refer to the foregoing embodiments. The polarity structure of the first polarity region A includes a first functional layer 2 and a first electrode structure that are stacked in a direction away from the semiconductor substrate 1. The first functional layer 2 includes a first passivation layer 2-1 and a first doped semiconductor layer 2-2 that are stacked in the direction away from the semiconductor substrate 1, and a side surface of the first passivation layer 2-1 facing towards the semiconductor substrate 1 is a polished surface. A second polarity structure is formed in the second polarity region B. A polarity structure of the second polarity region B includes a second functional layer 5 and a second electrode structure that are stacked in the direction away from the semiconductor substrate 1. The second functional layer 5 includes a second passivation layer 5-1 and a second doped semiconductor layer 5-2 that are stacked in the direction away from the semiconductor substrate 1. A side surface of the second passivation layer 5-1 facing towards the semiconductor substrate 1 is a polished surface. A doping type of the first doped semiconductor layer 2-2 is opposite to a doping type of the second doped semiconductor layer 5-2.

In operation 10, the semiconductor substrate 1 includes materials like monocrystalline silicon, germanium, or gallium arsenide. The doping type of the semiconductor substrate 1 may be N-type doping or P-type doping.

In an embodiment, the morphology of each of the light receiving surface and the shady surface of the semiconductor substrate 1 is first processed, so that the light receiving surface is a textured structure, such as a pyramid textured surface morphology and/or a corrosion pit textured morphology, and the shady surface is a polished surface, for example, a polished smooth surface morphology; and then each film layer structure is generated on the semiconductor substrate 1 to form an HBC solar cell. The process of the method for preparing the HBC solar cell is simplified, which is beneficial to large-scale mass production.

As an example, the processing a surface of the semiconductor substrate 1 to turn the light-receiving surface into a textured surface, and turn a surface of the first polarity region and a surface of the second polarity region into polished surfaces in operation 20 includes: texturing the light receiving surface and the shady surface of the semiconductor substrate 1; forming a mask M1 on the light receiving surface of the semiconductor substrate 1; then polishing the shady surface of the semiconductor substrate 1; and finally removing the mask M1.

The semiconductor substrate 1 is immersed in a texturing preparation liquid to realize double-sided texturing of the light-receiving surface and the shady surface; and then the mask M1 is formed at the light-receiving surface to protect the textured morphology of the light-receiving surface in the subsequent polished process. The mask M1 includes at least one of silicon oxide, silicon nitride, or silicon oxynitride.

The semiconductor substrate 1 of the prepared mask M1 is immersed in an alkaline polishing liquid to polish the shady surface of the semiconductor substrate 1, so that the shady surface forms a polished surface morphology. A predetermined thicknesses of the mask M1 after polishing the shady surface of the semiconductor substrate 1 is remained, which ensures the textured morphology of the light-receiving surface of the semiconductor substrate 1. A remaining thicknesses of the mask M1 may range from 10 nm to 100 nm, such as 10 nm, 50 nm, or 100 nm.

In some embodiments, the operation of removing the mask M1 is performed in a subsequent operation of preparing a polarity structure, i.e., after the shady surface of the semiconductor substrate 1 is polished, operation 30 is started.

In some embodiments, before processing a surface of the semiconductor substrate 1 to turn the light-receiving surface into a textured surface, and turn a surface of the first polarity region and a surface of the second polarity region into polished surfaces, the method further includes an operation of performing gettering treatment on the semiconductor substrate 1. By performing gettering treatment on the semiconductor substrate 1, a content of impurity elements in the semiconductor substrate 1 can be reduced, and the recombination of carriers is further reduced.

As an example, the process of performing gettering treatment on the semiconductor substrate 1 includes: removing a sacrificial layer of the semiconductor substrate 1 by wet etching; performing gettering treatment on the semiconductor substrate 1 by high-temperature phosphorus diffusion; and removing a gettering-treated layer formed in the gettering treatment on the semiconductor substrate 1 by wet etching. Therefore, the content of the impurity elements inside the semiconductor substrate 1 can be effectively lowered.

In some embodiments, the operation of forming the first polarity structure in the first polarity region A and the second polarity structure in the second polarity region B includes: forming the first functional layer 2 on the shady surface of the semiconductor substrate 1; etching a first region corresponding to the second polarity region B of the semiconductor substrate 1 to remove the first functional layer 2 in the first region and a part of the semiconductor substrate 1 with a first thickness; forming the second functional layer 5 on the shady surface of the semiconductor substrate 1, the second functional layer 5 covering the first functional layer 2; etching a second region in the first polarity region A of the semiconductor substrate 1 to remove the second functional layer 5 in the second region and a part of the first functional layer 2 with a second thickness; forming a conductive layer 8 over the shady surface of the semiconductor substrate 1, the conductive layer 8 covering the first functional layer 2 and the second functional layer 5; forming an opening in each of overlapping regions of the first functional layer 2 and the second functional layer 5, the opening at least penetrating the conductive layer 8 and at most exposing the first functional layer 2; and forming an electrode in each of the first region and the second region. The electrode is in contact with the conductive layer 8.

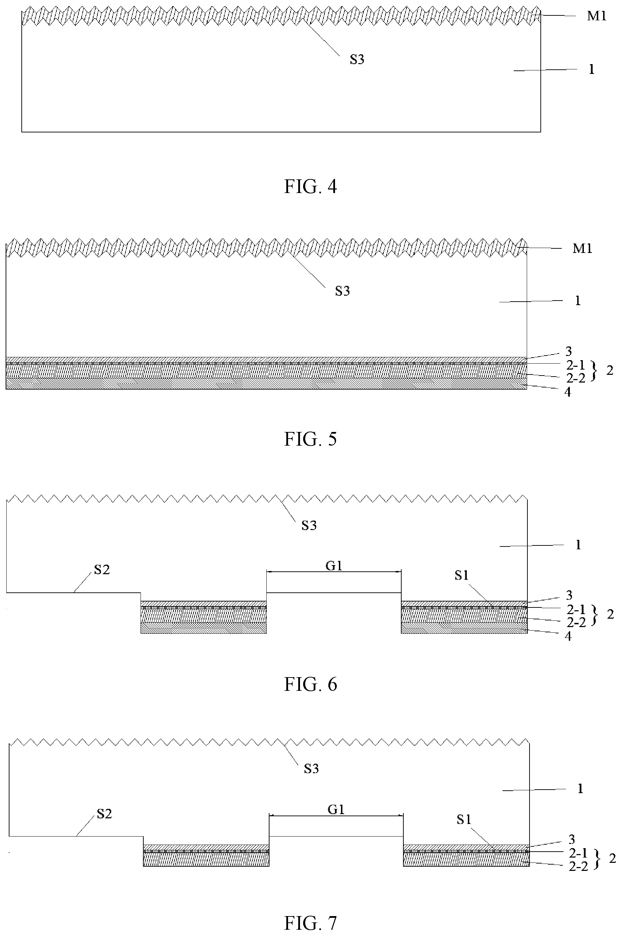

With reference to FIG. 4 to FIG. 11, a cell cross-sectional structure at each stage in a preparation process is shown, and an implementation of a method for preparing a back contact solar cell according to the present disclosure is specifically described.

As shown in FIG. 4, FIG. 4 shows a structure of the semiconductor substrate 1 after being subjected to a surface processing. In FIG. 4, a light-receiving surface (i.e., a third surface S3) of the semiconductor substrate 1 is a textured surface, a shady surface of the semiconductor substrate 1 is a polished surface, and a mask M1 is retained on the light-receiving surface.

As shown in FIG. 5, the first functional layer 2 is formed at the shady surface of the semiconductor substrate 1. The first passivation layer 2-1 and the first doped semiconductor layer 2-2 are prepared through low-pressure chemical vapor deposition (LPCVD) or plasma enhanced chemical vapor deposition (PECVD), and the first passivation layer 2-1 includes a tunnel oxide having a thickness ranging from 0.5 nm to 2.5 nm, like 0.5 nm, 1.5 nm, or 2.5 nm. The first doped semiconductor layer 2-2 includes doped polysilicon with a thickness ranging from 10 nm to 250 nm, like 10 nm, 50 nm, 150 nm, 250 nm, or the like. A doping method of the first doped semiconductor layer 2-2 is to perform high-temperature annealing crystallization after preparing in-situ doped amorphous/polycrystalline silicon, or to prepare an intrinsic amorphous/polycrystalline silicon layer for high-temperature diffusion for performing doping and crystallization.

In this embodiment, while the first functional layer 2 is formed, doping elements in the first doped semiconductor layer 2-2 enters the shady surface of the semiconductor substrate 1 through the first passivation layer 2-1 to form the doped substrate layer 3. The doping type of the doped substrate layer 3 is the same as the doping type of the first doped semiconductor layer 2-2. The thickness of the doped substrate layer 3 ranges from 5 nm to 200 nm, like 5 nm, 50 nm, 100 nm, or 200 nm.

In this embodiment, after the first functional layer 2 is formed, an insulation layer 4 is formed at the side of the first functional layer 2 away from the semiconductor substrate 1. The insulation layer 4 includes at least one of phosphorosilicate glass or borosilicate glass, silicon oxide, silicon nitride, and silicon oxynitride. The insulation layer 4 is configured to protect the first functional layer 2 of the rest of parts when the first functional layer 2 corresponding to the second polarity region B is etched.

As shown in FIG. 6 or FIG. 7, the first region corresponding to the second polarity region B of the semiconductor substrate 1 is etched to remove the first functional layer 2 in the first region and a part of the semiconductor substrate 1 with a first thickness. A range of the first region is the same as a range of the second polarity region B. The first opening G1 is formed by etching the first region and exposes the second surface S2. The distance between the first surface S1 and the third surface S3 is greater than the distance between the second surface S2 and the third surface S3. By removing a part of the semiconductor substrate 1 with a predetermined thickness, it can be ensured that no doped substrate layer 3 is left.

As an example, the insulation layer 4 is partially removed by laser etching, ink printing, or other manners; then the first doped semiconductor layer 2-2, the first passivation layer 2-1, and the doped substrate layer 3 are removed in a region without the insulation layer 4 through wet chemical etching. The wet chemical etching also includes a first functional layer 2 and an insulation layer 4 for synchronously removing front deposition or front edge winding to expose the mask M1, and then the mask M1 is removed.

As shown in FIG. 6, a part of the insulation layer 4 directly facing towards the first surface S1 is retained, to form insulation between the first functional layer 2 and the second functional layer 5 in a subsequent preparation process. Alternatively, as shown in FIG. 7, a part of the insulation layer 4 directly facing towards the first surface S1 is also removed, thereby improving passivation at the interface of the first polarity region A and the second polarity region B. Preparation is performed below based on the structure shown in FIG. 6.

In some embodiments, an etching liquid used for wet chemical etching includes an alkaline polishing liquid. Therefore, the second surface S2 can be polished while the doped substrate layer 3 is removed, so that the second surface S2 forms a polished surface to reduce surface defects.

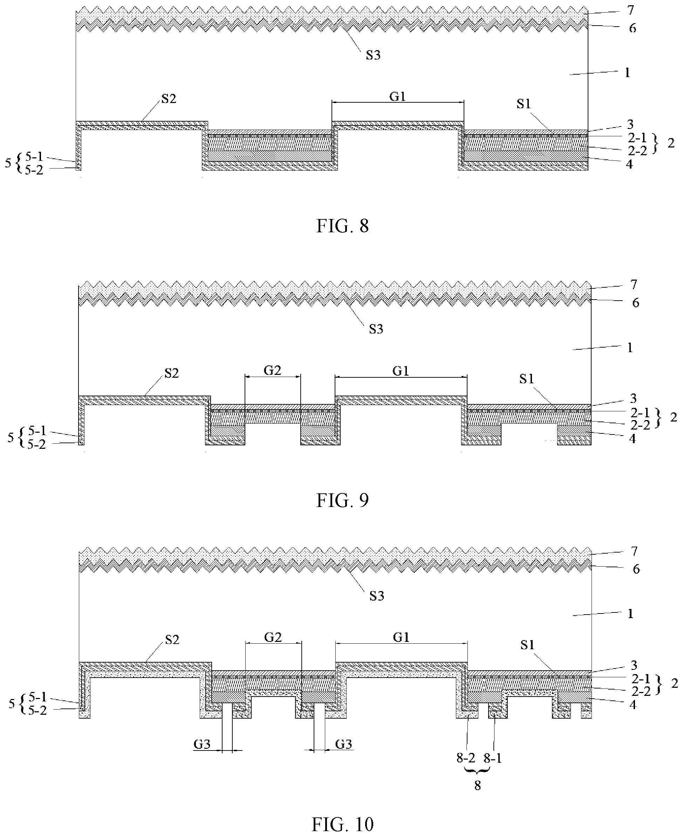

As shown in FIG. 8, the second functional layer 5 is formed at the shady surface of the semiconductor substrate 1 and covers the first functional layer 2. The second passivation layer 5-1 and the second doped semiconductor layer 5-2 are prepared at the shady surface of the semiconductor substrate 1 through low-pressure chemical vapor deposition (LPCVD) or plasma enhanced chemical vapor deposition (PECVD). The second passivation layer 5-1 includes intrinsic amorphous silicon with a thickness ranging from 1 nm to 15 nm, like 1 nm, 10 nm, or 15 nm. The second doped semiconductor layer 5-2 includes doped amorphous silicon and/or microcrystalline silicon with a thickness ranging from 1 nm to 60 nm, such as 1 nm, 30 nm, or 60 nm. The doping type of the second doped semiconductor layer 5-2 is opposite to the doping type of the first doped semiconductor layer 2-2.

In some embodiments, after forming the second functional layer 5 on the shady surface of the semiconductor substrate 1, the method further includes: forming a third functional layer 6 and an anti-reflection layer 7 sequentially on the light receiving surface of the semiconductor substrate 1. The third functional layer 6 and the anti-reflection layer 7 is also formed by low-pressure chemical vapor deposition (LPCVD) or plasma enhanced chemical vapor deposition (PECVD). The third functional layer 6 includes at least one of intrinsic amorphous silicon, a composite layer of intrinsic amorphous silicon and doped thin film silicon, silicon oxide, silicon nitride, silicon oxynitride, and aluminum oxide. The anti-reflection layer 7 includes at least one of silicon oxide, silicon nitride, silicon oxynitride, aluminum oxide, and a transparent conductive oxide.

As shown in FIG. 9, the second region in the first polarity region A of the semiconductor substrate 1 is etched to remove the second functional layer 5 in the second region and the part of the first functional layer 2 with the second thickness.

In an embodiment, the range of the second region is smaller than the range of the first polarity region A. A part of the first doped semiconductor layer 2-2 with a predetermined thickness is removed by at least removing the second doped semiconductor layer 5-2 in the second region, the second passivation layer 5-1, and the second opening G2 of the insulation layer 4, to ensure that no insulation layer 4 in the second region is left. The second doped semiconductor layer 5-2 and the second passivation layer 5-1 are removed by laser etching, and the insulation layer 4 and/or the laser oxide layer is removed by wet chemical etching.

As shown in FIG. 10, a conductive layer 8 is formed over the shady surface of the semiconductor substrate 1. The conductive layer 8 covers the first functional layer 2 and the second functional layer 5. An opening is formed in each of overlapping regions of the first functional layer 2 and the second functional layer 5. The opening at least penetrates the conductive layer 8 and at most exposes the first functional layer 2.

The conductive layer 8 may be prepared by physical vapor deposition (PVD) and chemical vapor deposition (CVD), which may be selected from reaction plasma deposition (ORR), magnetron sputtering, pulsed laser deposition (PLD), vacuum evaporation, atomic layer deposition (ALD), and the like. The conductive layer 8 includes at least one of zinc oxide, indium oxide, and tin oxide, and may be doped with at least one of gallium element, tin element, titanium element, zirconium element, molybdenum element, cerium element, fluorine element, tungsten element, or aluminum element. The thickness of the conductive layer 8 ranges from 10 nm to 150 nm, such as 10 nm, 50 nm, or 150 nm.

An opening is formed in each of overlapping regions of the first functional layer 2 and the second functional layer 5 by laser etching, ink printing, and/or wet chemical etching to form a third opening G3. The third opening G 3 at least penetrates the conductive layer 8, and at most exposes the first doped semiconductor layer 2-2. The conductive layer 8 is divided by the third opening G3 into the first conductive layer 8-1 and the second conductive layer 8-2. In the first direction D1, the first conductive layer 8-1 is located above the second opening G2 and extends towards the two sides, and the second conductive layer 8-2 is located above the first opening G1 and extends towards the two sides.

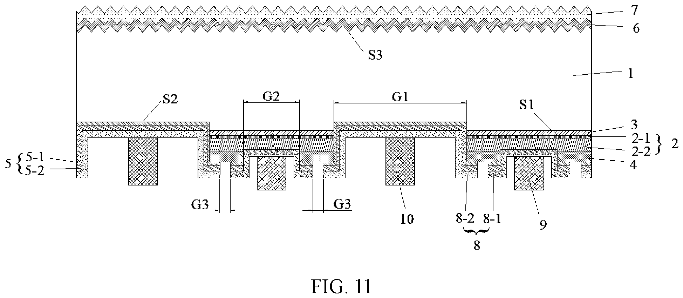

As shown in FIG. 11, an electrode is formed in each of the first region and the second region. The electrode is in contact with the conductive layer 8. The first electrode 9 is located at a side of the conductive layer 8-1 away from the semiconductor substrate 1, and the second electrode 10 is located at a side of the conductive layer 8-2 away from the semiconductor substrate 1. A method for preparing the first electrode 9 the second electrode 10 include screen printing of silver paste, inkjet printing of silver paste, electroplating, and the like.

An embodiment of the present disclosure further provides a battery assembly. The battery assembly includes the back contact solar cell as described above and the back contact solar cell prepared according to the foregoing method for preparing the back contact solar cell. The specific structure and principle of the back contact solar cell, and the specific operations of the method for preparing the back contact solar cell may refer to the foregoing embodiments, and details are omitted herein in an embodiment.

According to the battery assembly of the present disclosure, the recombination of carriers and interface defects in the back contact solar cell is less, and the battery assembly has the high open-circuit voltage and photoelectric conversion efficiency.

In the present disclosure, terms "comprise", "include" or any other variations thereof are meant to cover non-exclusive including, such that the process, method, article or terminal device including a series of elements do not only include those elements, but also include other elements that are not explicitly listed, or also include inherent elements of the process, method, article or terminal device. In a case that there are no more restrictions, an element qualified by the statement "comprises a ..." does not exclude the presence of additional identical elements in the process, method, article or terminal device that includes the said element. In addition, it should be noted that, within the scope of the method and apparatus in the implementations of the present disclosure, functions are performed in a sequence other than the sequences shown or discussed, including in a substantially identical sequence or in an opposite sequence. For example, the described methods may be performed in a different order than described, and various operations may also be added, omitted, or combined. In addition, features described with reference to predetermined examples may be combined in other examples.

Although embodiments of the present disclosure have been illustrated and described. The scope of the present disclosure shall be defined by the claims as appended and their equivalents.

## Claims

1. Aback contact solar cell, comprising:
a semiconductor substrate (1) having a light receiving surface and a shady surface opposite to the light receiving surface, the shady surface comprising a first polarity region (A) and a second polarity region (B) that are arranged alternately in a first direction (D1), the light receiving surface being a textured surface, and a surface of the first polarity region (A) and a surface of the second polarity region (B) being polished surfaces;
a first polarity structure formed in the first polarity region (A), the first polarity structure comprising a first functional layer (2) and a first electrode structure that are stacked in a direction away from the semiconductor substrate (1), the first functional layer (2) comprising a first passivation layer (2-1) and a first doped semiconductor layer (2-2) that are stacked in the direction away from the semiconductor substrate (1), and a side surface of the first passivation layer (2-1) facing towards the semiconductor substrate (1) being a polished surface; and
a second polarity structure formed in the second polarity region (B), the second polarity structure comprising a second functional layer (5) and a second electrode structure that are stacked in the direction away from the semiconductor substrate (1), the second functional layer (5) comprising a second passivation layer (5-1) and a second doped semiconductor layer (5-2) that are stacked in the direction away from the semiconductor substrate (1), and a side surface of the second passivation layer (5-1) facing towards the semiconductor substrate (1) being a polished surface,
wherein a doping type of the first doped semiconductor layer (2-2) is opposite to a doping type of the second doped semiconductor layer (5-2).

2. The back contact solar cell according to claim 1, wherein:
the second functional layer (5) at least partially extends to the first polarity region (A);
a first orthographic projection of the first functional layer (2) on the semiconductor substrate (1) at least partially overlaps with a second orthographic projection of the second functional layer (5) on the semiconductor substrate (1); and
the first functional layer (2) is in direct contact with the second functional layer (5); or an insulation layer (4) is arranged between the first functional layer (2) and the second functional layer (5), the insulation layer (4) comprising at least one of phosphorosilicate glass or borosilicate glass, silicon oxide, silicon nitride, or silicon oxynitride.

3. The back contact solar cell according to claim 2, wherein an opening (G3) is defined between the first electrode structure and the second electrode structure adjacent to the first electrode structure, a third orthographic projection of the opening (G3) on the semiconductor substrate (1) being located in an overlapping region of the first orthographic projection and the second orthographic projection.

4. The back contact solar cell according to any one of claims 1 to 3, wherein:
the first electrode structure comprises a first conductive layer (8-1) and a first electrode (9), the first conductive layer (8-1) being located at a side of the first doped semiconductor layer (2-2) away from the first passivation layer (2-1), and the first electrode (9) being located at a side of the first conductive layer (8-1) away from the first doped semiconductor layer (2-2); and
the second electrode structure comprises a second conductive layer (8-2) and a second electrode (10), the second conductive layer (8-2) being located at a side of the second doped semiconductor layer (5-2) away from the second passivation layer (5-1), and second first electrode (10) being located at a side of the second conductive layer (8-2) away from the second doped semiconductor layer (5-2);
each of a material of the first conductive layer (8-1) and the second conductive layer (8-2) comprises at least one of zinc oxide, indium oxide, and tin oxide, each of the first conductive layer (8-1) and the second conductive layer (8-2) being doped with at least one of gallium element, tin element, titanium element, zirconium element, molybdenum element, cerium element, fluorine element, tungsten element, and aluminum element, and each of the first conductive layer and the second conductive layer having a thickness ranging from 10 nm to 150 nm.

5. The back contact solar cell according to any one of claims 1 to 3, wherein the semiconductor substrate (1) further comprises a doped substrate layer (3) located in the first polarity region (A) and formed on a side of the first polarity region (A) close to the first passivation layer (2-1), a doping type of the doped substrate layer (3) being the same as the doping type of the first doped semiconductor layer (2-2), and the doped substrate layer (3) having a thickness ranging from 5 nm to 200 nm;
optionally, a distance between the surface of the first polarity region (A) and the light receiving surface is greater than a distance between the surface of the second polarity region (B) and the light receiving surface.

6. The back contact solar cell according to any one of claims 1 to 3, wherein:
the first passivation layer (2-1) comprises a tunnel oxide and has a thickness ranging from 0.5 nm to 2.5 nm;
the first doped semiconductor layer (2-2) comprises doped polysilicon and has a thickness ranging from 10 nm to 250 nm;
the second passivation layer (5-1) comprises intrinsic amorphous silicon and has a thickness ranging from 1 nm to 15 nm; and
the second doped semiconductor layer (5-2) comprises doped amorphous silicon and/or microcrystalline silicon and has a thickness ranging from 1 nm to 60 nm.

7. The back contact solar cell according to any one of claims 1 to 3, further comprising a third functional layer (6) and an anti-reflection layer (7) formed on the light-receiving surface of the semiconductor substrate (1), the third functional layer (6) and the anti-reflection layer (7) being stacked in the direction away from the semiconductor substrate (1), the third functional layer (6) comprising at least one of intrinsic amorphous silicon, a composite layer of intrinsic amorphous silicon and doped thin film silicon, silicon oxide, silicon nitride, silicon oxynitride, and aluminum oxide, and the anti-reflection layer (7) comprising at least one of silicon oxide, silicon nitride, silicon oxynitride, aluminum oxide, and transparent conductive oxide.

8. A method for preparing a back contact solar cell, comprising:
providing (10) a semiconductor substrate, the semiconductor substrate having a light-receiving surface and a shady surface opposite to the light-receiving surface, the shady surface comprising a first polarity region and a second polarity region that are arranged alternately in a first direction;
processing (20) a surface of the semiconductor substrate to turn the light-receiving surface into a textured surface, and turn a surface of the first polarity region and a surface of the second polarity region into polished surfaces; and
forming (30) a first polarity structure in the first polarity region and a second polarity structure in the second polarity region,
wherein the first polarity structure comprises a first functional layer and a first electrode structure that are stacked in a direction away from the semiconductor substrate, the first functional layer comprising a first passivation layer and a first doped semiconductor layer that are stacked in the direction away from the semiconductor substrate, and a side surface of the first passivation layer facing towards the semiconductor substrate being a polished surface,
wherein a second polarity structure comprises a second functional layer and a second electrode structure that are stacked in the direction away from the semiconductor substrate, the second functional layer comprising a second passivation layer and a second doped semiconductor layer that are stacked in the direction away from the semiconductor substrate, and a side surface of the second passivation layer facing towards the semiconductor substrate being a polished surface, and
wherein a doping type of the first doped semiconductor layer is opposite to a doping type of the second doped semiconductor layer.

9. The method for preparing a back contact solar cell according to claim 8, wherein said processing (2) the surface of the semiconductor substrate to turn the light-receiving surface into the textured surface, and turn the surface of the first polarity region and the surface of the second polarity region into the polished surfaces comprises:
texturing the light receiving surface and the shady surface of the semiconductor substrate;
forming a mask on the light receiving surface of the semiconductor substrate;
polishing the shady surface of the semiconductor substrate; and
removing the mask.

10. The method for preparing a back contact solar cell according to claim 9, wherein:
the mask has a remaining thickness after said polishing the shady surface of the semiconductor substrate ranging from 10 nm to 100 nm; and
the mask is made of at least one of silicon oxide, silicon nitride, or silicon oxynitride.

11. The method for preparing a back contact solar cell according to any one of claims 8 to 10, further comprising, before said processing (2) the surface of the semiconductor substrate to turn the light-receiving surface into the textured surface, and turn the surface of the first polarity region and the surface of the second polarity region into the polished surfaces:
performing gettering treatment on the semiconductor substrate.

12. The method for preparing a back contact solar cell according to claim 11, wherein said performing gettering treatment on the semiconductor substrate comprises:
removing a sacrificial layer of the semiconductor substrate by wet etching;
performing gettering treatment on the semiconductor substrate by high-temperature phosphorus diffusion; and
removing, by wet etching, a gettering-treated layer formed in the gettering treatment on the semiconductor substrate.

13. The method for preparing a back contact solar cell according to any one of claims 8 to 10, wherein said forming (3) a first polarity structure in the first polarity region and a second polarity structure in the second polarity region comprises:
forming the first functional layer on the shady surface of the semiconductor substrate;
etching a first region corresponding to the second polarity region of the semiconductor substrate to remove the first functional layer in the first region and a part of the semiconductor substrate with a first thickness;
forming the second functional layer on the shady surface of the semiconductor substrate, the second functional layer covering the first functional layer;
etching a second region in the first polarity region of the semiconductor substrate to remove the second functional layer in the second region and a part of the first functional layer with a second thickness;
forming a conductive layer over the shady surface of the semiconductor substrate, the conductive layer covering the first functional layer and the second functional layer;
forming an opening in each of overlapping regions of the first functional layer and the second functional layer, the opening at least penetrating the conductive layer and at most exposing the first functional layer; and
forming an electrode in each of the first region and the second region, the electrode being in contact with the conductive layer;
optionally, the first functional layer in the first region and the part of the semiconductor substrate with the first thickness are removed by using a wet chemical etching liquid, the wet chemical etching liquid comprising an alkaline polishing liquid.

14. The method for preparing a back contact solar cell according to claim 13, further comprising, after said forming (3) the second functional layer on the shady surface of the semiconductor substrate:
forming a third functional layer and an anti-reflection layer sequentially on the light receiving surface of the semiconductor substrate.

15. A battery assembly, comprising the back contact solar cell according to any one of claims 1 to 7, or a back contact solar cell prepared by the method for preparing a back contact solar cell according to any one of claims 8 to 14.
